# EUROPÄISCHE PATENTANMELDUNG

(11) **EP 4 697 875 A1**
(43) Veröffentlichungstag der Anmeldung: **18.02.2026**
(21) Anmeldenummer: 24194095.6
(22) Anmeldetag: 12.08.2024
(51) Int. Cl.: H05K 7/20, H01L 23/467

(54) **ANORDNUNG MIT EINEM ERSTEN KÜHLKÖRPER UND EINEM ZWEITEN KÜHLKÖRPER**

(71) Anmelder: Siemens Aktiengesellschaft, 80333 München (DE)
(72) Erfinder: Kögler, Roman, 90403 Nürnberg (DE); Roppelt, Bernd, 96173 Unterhaid (DE); Schmenger, Jens, 91301 Forchheim (DE)
(74) Vertreter: Siemens Patent Attorneys

(57) **Zusammenfassung**

Die Erfindung betrifft eine Leistungshalbleiteranordnung (2) mit einem ersten Kühlkörper (4) und einem zweiten Kühlkörper (6), wobei die Kühlkörper (4, 6) jeweils eine ebene Oberfläche (8), eine erste Seitenfläche (10) und eine gegenüber der ersten Seitenfläche (10) angeordnete zweite Seitenfläche (12) aufweisen, wobei auf den Oberflächen (8) der Kühlkörper (4, 6) jeweils zumindest eine Leistungshalbleiterschaltung (24) verbunden ist. Um die Lebensdauer der Leistungshalbleiteranordnung (2) zu verbessern wird vorgeschlagen, dass der erste Kühlkörper (4) eine Mehrzahl erster Rippen (16) und der zweite Kühlkörper (6) eine Mehrzahl zweiter Rippen (18) und dritter Rippen (20) aufweist, wobei die Rippen (16, 18, 20) des jeweiligen Kühlkörpers (4, 6) parallel von der ersten Seitenfläche (10) zur zweiten Seitenfläche (12) entlang einer Luftstromrichtung (22) verlaufend angeordnet sind, wobei der zweite Kühlkörper (6) entlang der Luftstromrichtung (22) stromab des ersten Kühlkörpers (4) angeordnet ist, wobei die zweite Seitenfläche (12) des ersten Kühlkörpers (4) unmittelbar an die erste Seitenfläche (10) des zweiten Kühlkörpers (6) angrenzt und wobei eine Anzahl der zweiten Rippen (18) des zweiten Kühlkörpers (6) gleich einer Anzahl der ersten Rippen (16) des ersten Kühlkörpers (4) ist.

## Beschreibung

Die Erfindung betrifft eine Leistungshalbleiteranordnung mit einem ersten Kühlkörper und einem zweiten Kühlkörper.

Ferner betrifft die Erfindung einen Stromrichter mit mindestens einer derartigen Leistungshalbleiteranordnung.

Darüber hinaus betrifft die Erfindung ein Verfahren zur Herstellung einer Leistungshalbleiteranordnung mit einem ersten Kühlkörper und einem zweiten Kühlkörper.

Derartige Leistungshalbleiteranordnungen kommen in der Regel in einem Stromrichter zum Einsatz. Unter einem Stromrichter ist beispielsweise ein Gleichrichter, ein Wechselrichter, ein Umrichter oder ein Gleichspannungswandler zu verstehen. Um beispielsweise die Verlustwärme einer Leistungshalbleiterschaltung einer derartigen Leistungshalbleiteranordnung abzuführen, kommen üblicherweise Kühlkörper zum Einsatz. Die Wärmeabfuhr kann beispielsweise mittels forcierter Luftkühlung geschehen.

Die Offenlegungsschrift EP 4 128 337 A1 beschreibt ein Leistungsmodul mit mindestens zwei Leistungseinheiten, welche jeweils mindestens einen Leistungshalbleiter und ein Substrat umfassen. Um den erforderlichen Bauraum des Leistungsmoduls zu verringern und eine Entwärmung zu verbessern, wird vorgeschlagen, dass der jeweils mindestens eine Leistungshalbleiter, insbesondere stoffschlüssig, mit dem jeweiligen Substrat verbunden ist, wobei die Substrate der mindestens zwei Leistungseinheiten jeweils unmittelbar stoffschlüssig mit einer Oberfläche eines gemeinsamen Kühlkörpers verbunden sind.

Werden beispielsweise zwei identische ein einer Reihe angeordnete Kühlkörper einseitig von einer Kühlluftströmung durchflossen, erwärmt sich der stromab abgeordnete Kühlkörper bei gleicher Verlustleistung der Leistungshalbleiterschaltungen stärker. Relevant für Lebensdauerauslegung der Leistungshalbleiterschaltungen auf den Kühlkörpern ist der wärmste Leistungshalbleiter. Ein derartiger Leistungshalbleiter kann unter anderem ein Transistor sein. Derartige Transistoren können unter anderem als Insulated-Gate-BipolarTransistoren (IGBTs) oder als Wide-Bandgap-Transistoren ausgeführt sein. Die Wide-Bandgap-Transistoren können beispielsweise in Siliziumcarbid (SiC)- oder Galliumnitrid (GaN)-Technologie realisiert sein und ermöglichen unter anderem höhere Schaltfrequenzen.

Vor diesem Hintergrund ist es eine Aufgabe der vorliegenden Erfindung, die Lebensdauer einer Leistungshalbleiteranordnung, welche zwei einseitig gekühlte Kühlkörper umfasst, zu verbessern.

Diese Aufgabe wird erfindungsgemäß gelöst durch eine Leistungshalbleiteranordnung mit einem ersten Kühlkörper und einem zweiten Kühlkörper, wobei die Kühlkörper jeweils eine ebene Oberfläche, eine erste Seitenfläche und eine gegenüber der ersten Seitenfläche angeordnete zweite Seitenfläche aufweisen, wobei auf den Oberflächen der Kühlkörper jeweils zumindest eine Leistungshalbleiterschaltung verbunden ist, wobei der erste Kühlkörper eine Mehrzahl erster Rippen und der zweite Kühlkörper eine Mehrzahl zweiter Rippen und dritter Rippen aufweist, wobei die Rippen des jeweiligen Kühlkörpers parallel von der ersten Seitenfläche zur zweiten Seitenfläche entlang einer Luftstromrichtung verlaufend angeordnet sind, wobei der zweite Kühlkörper entlang der Luftstromrichtung stromab des ersten Kühlkörpers angeordnet ist, wobei die zweite Seitenfläche des ersten Kühlkörpers unmittelbar an die erste Seitenfläche des zweiten Kühlkörpers angrenzt und wobei eine Anzahl der zweiten Rippen des zweiten Kühlkörpers gleich einer Anzahl der ersten Rippen des ersten Kühlkörpers ist.

Ferner wird die Aufgabe erfindungsgemäß durch einen Stromrichter mit mindestens einer derartigen Leistungshalbleiteranordnung gelöst.

Überdies wird die Aufgabe erfindungsgemäß durch ein Verfahren zur Herstellung einer Leistungshalbleiteranordnung mit einem ersten Kühlkörper und einem zweiten Kühlkörper, wobei die Kühlkörper jeweils eine ebene Oberfläche, eine erste Seitenfläche und eine gegenüber der ersten Seitenfläche angeordnete zweite Seitenfläche aufweisen, wobei auf den Oberflächen der Kühlkörper jeweils zumindest eine Leistungshalbleiterschaltung verbunden wird, wobei der erste Kühlkörper eine Mehrzahl erster Rippen und der zweite Kühlkörper eine Mehrzahl zweiter Rippen und dritter Rippen aufweist, wobei die Rippen des jeweiligen Kühlkörpers parallel von der ersten Seitenfläche zur zweiten Seitenfläche entlang einer Luftstromrichtung verlaufend angeordnet sind, wobei der zweite Kühlkörper entlang der Luftstromrichtung stromab des ersten Kühlkörpers angeordnet wird, wobei die zweite Seitenfläche des ersten Kühlkörpers unmittelbar an die erste Seitenfläche des zweiten Kühlkörpers angrenzend angeordnet wird und wobei eine Anzahl der zweiten Rippen des zweiten Kühlkörpers gleich einer Anzahl der ersten Rippen des ersten Kühlkörpers ist.

Darüber hinaus wird die Aufgabe erfindungsgemäß durch eine Leistungshalbleiteranordnung mit einem ersten Kühlkörper und einem zweiten Kühlkörper, wobei die Kühlkörper jeweils eine ebene Oberfläche, eine erste Seitenfläche und eine gegenüber der ersten Seitenfläche angeordnete zweite Seitenfläche aufweisen, wobei auf den Oberflächen der Kühlkörper jeweils zumindest eine Leistungshalbleiterschaltung verbunden ist, wobei der erste Kühlkörper und der zweite Kühlkörper eine Mehrzahl von Rippen aufweisen, welche jeweils parallel von der ersten Seitenfläche zur zweiten Seitenfläche des jeweiligen Kühlkörpers entlang einer Luftstromrichtung einer Kühlluftströmung verlaufend angeordnet sind, wobei der zweite Kühlkörper entlang der Luftstromrichtung stromab des ersten Kühlkörpers angeordnet ist, wobei die zweite Seitenfläche des ersten Kühlkörpers unmittelbar an die erste Seitenfläche des zweiten Kühlkörpers angrenzt und wobei die Rippen der Kühlkörper jeweils eine Kontaktfläche aufweisen, welche in einer fluidtechnischen Verbindung zur Kühlluftströmung steht, wobei die Kontaktfläche der Rippen des zweiten Kühlkörpers größere als die Kontaktfläche der Rippen des ersten Kühlkörpers 4 ist.

Die in Bezug auf die Leistungshalbleiteranordnung nachstehend angeführten Vorteile und bevorzugten Ausgestaltungen lassen sich sinngemäß auf den Stromrichter und das Herstellungsverfahren übertragen.

Der Erfindung liegt die Überlegung zugrunde, die Lebensdauer einer Leistungshalbleiteranordnung mit zwei einseitig gekühlten Kühlkörpern dadurch zu verbessern, dass eine gleichmäßige Entwärmung der Leistungshalbleiterschaltungen stattfindet. Die Kühlkörper weisen jeweils eine ebene Oberfläche, eine erste Seitenfläche und eine gegenüber der ersten Seitenfläche angeordnete zweite Seitenfläche auf. Die Kühlkörper können beispielsweise im Wesentlichen ebene Seitenflächen aufweisen. Insbesondere sind die Kühlkörper im Wesentlichen quaderförmig ausgeführt. Der erste Kühlkörper und der zweite Kühlkörper weisen eine Mehrzahl von, insbesondere geradlinig verlaufenden, Rippen auf, welche jeweils parallel von der ersten Seitenfläche zur zweiten Seitenfläche des jeweiligen Kühlkörpers entlang einer Luftstromrichtung verlaufend angeordnet sind. Der zweite Kühlkörper ist entlang der Luftstromrichtung stromab des ersten Kühlkörpers angeordnet, wobei die zweite Seitenfläche des ersten Kühlkörpers unmittelbar an die erste Seitenfläche des zweiten Kühlkörpers angrenzt. Hierbei können sich die Kühlkörper berühren oder bis maximal 1 mm, insbesondere maximal 500 µm, voneinander beabstandet sein. Die Kühlkörper sind jedoch nicht über Verbindungselemente wie Klebstoff oder eine Dichtungsmasse miteinander verbunden.

Die Rippen der Kühlkörper weisen jeweils eine Kontaktfläche auf, welche in einer fluidtechnischen Verbindung zur Kühlluftströmung steht, wobei die Kontaktfläche der Rippen des zweiten Kühlkörpers größer als die Kontaktfläche der Rippen des ersten Kühlkörpers ist. Beispielseise weist der erste Kühlkörper eine Mehrzahl erster Rippen und der zweite Kühlkörper eine Mehrzahl zweiter Rippen und dritter Rippen auf, wobei eine Anzahl der zweiten Rippen des zweiten Kühlkörpers gleich einer Anzahl der ersten Rippen des ersten Kühlkörpers ist. Aufgrund der zusätzlichen dritten Rippen des stromab angeordneten zweiten Kühlkörpers wird die Kontaktfläche zur Kühlluftströmung vergrößert, was zu einer verbesserten Entwärmung der Leistungshalbleiterschaltungen führt. Da die Kühlluftströmung bereits durch den ersten Kühlkörper erwärmt ist, können durch die zusätzlichen dritten Rippen des stromab angeordneten zweiten Kühlkörpers näherungsweise gleiche Temperaturverhältnisse beider Kühlkörper eingestellt werden, was zu einer Lebensdauerverbesserung der Leistungshalbleiteranordnung führt.

Eine weitere Ausführungsform sieht vor, dass die ersten Rippen des ersten Kühlkörpers und die zweiten Rippen des zweiten Kühlkörpers fluchtend angeordnet sind. Auf diese Weise verlängern die ersten Rippen die zweiten Rippen, was strömungstechnisch günstig ist. Insbesondere sind die ersten Rippen des ersten Kühlkörpers und die zweiten Rippen des zweiten Kühlkörpers entlang einer geraden Linie angeordnet. Somit wird eine gleichmäßige Entwärmung der Leistungshalbleiterschaltungen erreicht, was zu einer Lebensdauerverbesserung der Leistungshalbleiteranordnung führt.

Eine weitere Ausführungsform sieht vor, dass jeweils mindestens zwei, insbesondere mindestens drei, Leistungshalbleiterschaltungen auf den Oberflächen der jeweiligen Kühlkörper verbunden sind, wobei die Leistungshalbleiterschaltungen entlang der Luftstromrichtung angeordnet sind. Beispielsweise sind jeweils drei identische Leistungshalbleiterschaltungen auf einem Kühlkörper verbunden, welche unter anderem jeweils eine Halbbrücke umfassen können und/oder einem dreiphasigen Stromrichter zugeordnet sein können. Durch eine derartige Anordnung wird ein einfacher modularer Aufbau ermöglicht.

Eine weitere Ausführungsform sieht vor, dass zumindest eine Leistungshalbleiterschaltung des ersten Kühlkörpers dieselbe Schaltungstopologie aufweist wie zumindest eine Leistungshalbleiterschaltung des zweiten Kühlkörpers. Insbesondere weist zumindest eine Leistungshalbleiterschaltung des ersten Kühlkörpers dieselben Halbleiterbauelemente im selben Layout auf wie zumindest eine Leistungshalbleiterschaltung des zweiten Kühlkörpers. Durch eine derartige Anordnung ist beispielsweise eine einfache und kostengünstige Skalierbarkeit der Leistungshalbleiteranordnung erreichbar. Durch die zusätzlichen dritten Rippen des stromab angeordneten zweiten Kühlkörpers ist auch bei derselben Schaltungstopologie, welche mit derselben Verlustleistung einhergehen kann, eine gleichmäßige Entwärmung erreichbar, was zu einer Lebensdauerverbesserung der Leistungshalbleiteranordnung führt.

Eine weitere Ausführungsform sieht vor, dass die Leistungshalbleiterschaltungen jeweils ein Substrat umfassen, welches stoffschlüssig auf der Oberfläche des jeweiligen Kühlkörpers verbunden ist. Die stoffschlüssige Verbindung ist unter anderem durch Löten oder Sintern herstellbar. Eine derartige direkte Verbindung des Substrats mit dem jeweiligen Kühlkörper führt in Kombination mit den zusätzlichen dritten Rippen des stromab angeordneten zweiten Kühlkörpers, insbesondere im Vergleich zu Leistungsmodulen mit zusätzlicher Bondenplatte, welche mit Wärmeleitpaste auf dem jeweiligen Kühlkörper kontaktiert werden, zu einer verbesserten und gleichmäßigeren thermischen Anbindung.

Eine weitere Ausführungsform sieht vor, dass zweite Rippen und dritte Rippen des zweiten Kühlkörpers alternierend angeordnet sind. Eine derartige Anordnung ermöglicht eine gleichmäßige Entwärmung der Leistungshalbleiterschaltungen quer zur Luftstromrichtung, was zu einer Lebensdauerverbesserung der Leistungshalbleiteranordnung führt.

Eine weitere Ausführungsform sieht vor, dass der Quotient aus einer Anzahl von Rippen des zweiten Kühlkörpers zu einer Anzahl von Rippen des ersten Kühlkörpers ganzzahlig ist. Eine derartige Anordnung ermöglicht eine gleichmäßige Entwärmung quer zur Luftstromrichtung, was zu einer Lebensdauerverbesserung der Leistungshalbleiteranordnung führt.

Eine weitere Ausführungsform sieht vor, dass die Kühlkörper jeweils monolithisch ausgeführt sind. Insbesondere sind Grundplatte und Rippen des jeweiligen Kühlkörper einstückig ausgeführt. Eine monolithische Ausführung ist kostengünstig und senkt, insbesondere zu eingepressten Rippen, den thermischen Widerstand zwischen Rippen und Grundplatte.

Eine weitere Ausführungsform sieht vor, dass die Kühlkörper jeweils mittels eines Strangpressverfahrens hergestellt sind. Insbesondere ist der Kühlkörper aus einer Aluminiumlegierung als Endlosprofil mittels Strangpressen hergestellt. Beispielsweise ist beim Strangpressen eine Aluminiumlegierung mit einem Siliziumanteil von 0,1 % bis 1,0 %, insbesondere von 0,1 % bis 0,6, verwendbar. Somit ist beim Strangpressen, insbesondere im Vergleich zu einem gegossenen Grundkörper, ein niedriger Siliziumanteil verwendbar, sodass durch das Strangpressen mit einer derartigen Legierung eine verbesserte Wärmeleitfähigkeit erreichbar ist. Ferner ist das Strangpressen von Endlosprofilen kostengünstig und einfach.

Eine weitere Ausführungsform sieht vor, dass die Oberfläche des ersten Kühlkörpers bündig zur Oberfläche des zweiten Kühlkörpers verlaufend angeordnet ist, wobei eine erste Länge der ersten Rippen einer zweiten Länge der zweiten und dritten Rippen entspricht, sodass die Rippen auf einer den Oberflächen gegenüberliegenden Seite bündig abschließen. Insbesondere ist die Länge der Rippen in Luftstromrichtung konstant. Durch eine derartige Anordnung wird Bauraum eingespart und es ist zusätzlich eine gleichmäßige Entwärmung der Leistungshalbleiterschaltungen erreichbar.

Eine weitere Ausführungsform sieht vor, dass ein als Drucklüfter konfigurierter Lüfter unmittelbar an die erste Seitenfläche des ersten Kühlkörpers angrenzend angeordnet ist oder ein als Sauglüfter konfigurierter Lüfter unmittelbar an die zweite Seitenfläche des zweiten Kühlkörpers angrenzend angeordnet ist. Durch die seitliche Anordnung der Lüfter wird Bauraum eingespart.

Eine weitere Ausführungsform sieht vor, dass die Rippen des zweiten Kühlkörpers einen höheren Luftwiderstand aufweisen als die Rippen des ersten Kühlkörpers. Ein erhöhter Luftwiderstand kann unter anderem durch eine höhere Anzahl und/oder durch eine andere Geometrie der Rippen des zweiten Kühlkörpers erreicht werden. Ein erhöhter Luftwiderstand durch andere Geometrie der Rippen wird unter anderem durch eine größere Länge erreicht, wodurch eine gleichmäßige Entwärmung der Leistungshalbleiterschaltungen erreicht werden kann.

Eine weitere Ausführungsform sieht vor, dass zumindest die Rippen des zweiten Kühlkörpers eine Profilierung aufweisen. Beispielsweise weisen die des zweiten Kühlkörpers eine wellenförmige Profilierung auf. Insbesondere weisen die profilierten Rippen entlang der Luftstromrichtung ein gleichbleibendes Querschittsprofil auf, sodass auch der zweite Kühlkörper kostengünstig durch Strangpressen herstellbar ist. Die Profilierung führt zu einer verbesserten Entwärmung der Leistungshalbleiterschaltungen des zweiten Kühlkörpers.

Im Folgenden wird die Erfindung anhand der in den Figuren dargestellten Ausführungsbeispiele näher beschrieben und erläutert.

Es zeigen:
- FIG 1: eine schematische dreidimensionale Darstellung einer ersten Ausführungsform einer Leistungshalbleiteranordnung,
- FIG 2: eine schematische Schnittdarstellung einer zweiten Ausführungsform einer Leistungshalbleiteranordnung,
- FIG 3: eine schematische Schnittdarstellung einer dritten Ausführungsform einer Leistungshalbleiteranordnung,
- FIG 4: eine schematische Schnittdarstellung einer vierten Ausführungsform einer Leistungshalbleiteranordnung,
- FIG 5: eine schematische Schnittdarstellung einer fünften Ausführungsform einer Leistungshalbleiteranordnung,
- FIG 6: eine schematische Schnittdarstellung einer sechsten Ausführungsform einer Leistungshalbleiteranordnung,
- FIG 7: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

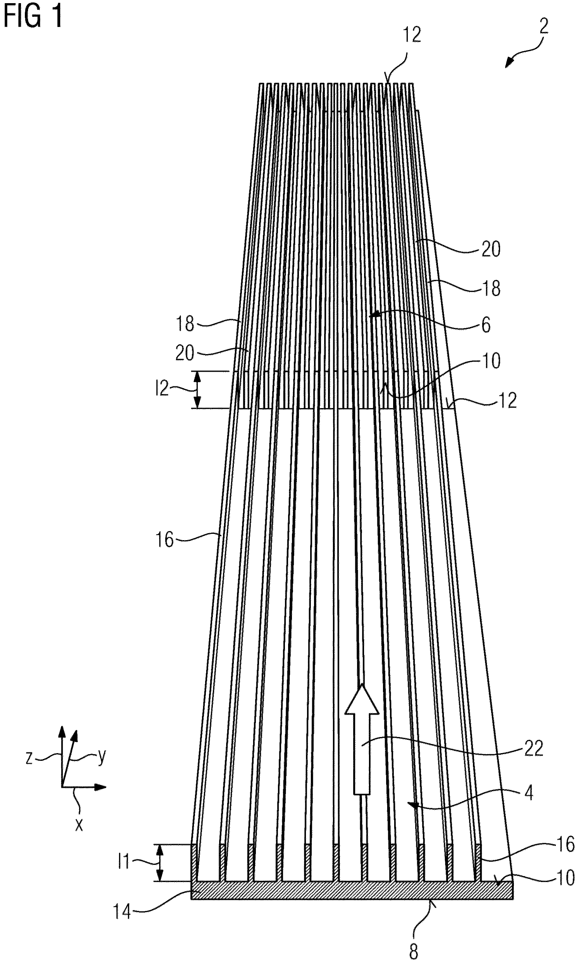

FIG 1 zeigt eine schematische dreidimensionale Darstellung einer ersten Ausführungsform einer Leistungshalbleiteranordnung 2, welche einen ersten Kühlkörper 4 und einen zweiten Kühlkörper 6 umfasst. Die Kühlkörper 4, 6 weisen jeweils eine ebene Oberfläche 8, eine erste Seitenfläche 10 und eine gegenüber der ersten Seitenfläche 10 angeordnete zweite Seitenfläche 12 auf, wobei die zweite Seitenfläche 12 des ersten Kühlkörpers 4 unmittelbar an die erste Seitenfläche 10 des zweiten Kühlkörpers 6 angrenzt. Die ebene Oberfläche 8 definiert eine xy-Ebene. Hierbei können sich die Kühlkörper 4, 6 berühren oder bis maximal 1 mm, insbesondere maximal 500 µm, voneinander beabstandet sein, die Kühlkörper 4, 6 sind jedoch nicht über Verbindungselemente wie Klebstoff oder eine Dichtungsmasse miteinander verbunden. Ferner weisen die Kühlkörper 4, 6 jeweils eine Grundplatte 14 auf, wobei der erste Kühlkörper 4 eine Mehrzahl erster Rippen 16 und der zweite Kühlkörper 6 eine Mehrzahl zweiter Rippen 18 und dritter Rippen 20 aufweist. Die Rippen 16, 18, 20 erstrecken sich senkrecht zur xy-Ebene in z-Richtung. Darüber hinaus sind die Rippen 16, 18, 20 des jeweiligen Kühlkörpers 4, 6 geradlinig parallel von der ersten Seitenfläche 10 zur zweiten Seitenfläche 12 entlang einer Luftstromrichtung 22 verlaufend angeordnet, wobei der zweite Kühlkörper 6 entlang der Luftstromrichtung 22 stromab des ersten Kühlkörpers 4 angeordnet ist. Auf den ebenen Oberflächen 8 der Kühlkörper 4, 6 sind jeweils beispielhaft drei Leistungshalbleiterschaltungen entlang der Luftstromrichtung 22 verbunden, wobei die Leistungshalbleiterschaltungen aus Gründen der Übersichtlichkeit in FIG 1 nicht dargestellt sind.

Eine Anzahl erster der zweiten Rippen 18 des zweiten Kühlkörpers 6 entspricht einer Anzahl der ersten Rippen 16 des ersten Kühlkörpers 4. Ferner sind die ersten Rippen 16 des ersten Kühlkörpers 4 und die zweiten Rippen 18 des zweiten Kühlkörpers 6 fluchtend angeordnet, sodass die jeweiligen zweiten Rippen 18 die ersten Rippen 16 verlängern. Ferner sind die zweiten Rippen 18 und dritten Rippen 20 des zweiten Kühlkörpers 6 alternierend angeordnet. Beispielhaft weist der erste Kühlkörper zehn erste Rippen 16 auf, während der zweite Kühlkörpers 6 zehn zweite Rippen 18 und zehn dritte Rippen 20 aufweist. Somit ist der Quotient aus einer Anzahl von Rippen 18, 20 des zweiten Kühlkörpers 6 zu einer Anzahl von Rippen 16 des ersten Kühlkörpers 4 ganzzahlig. Auf diese Weise werden die Temperaturen beider Kühlkörper bei einem Betrieb der Leistungshalbleiterschaltungen angepasst.

Die Kühlkörper 4, 6 sind jeweils monolithisch ausgeführt und aus einer Aluminiumlegierung mittels eines Strangpressverfahrens hergestellt. Die Aluminiumlegierung enthält beispielsweise einen Siliziumanteil von 0,1 % bis 1,0 %, insbesondere von 0,1 % bis 0,6. Des Weiteren ist die Oberfläche 8 des ersten Kühlkörpers 4 bündig zur Oberfläche 8 des zweiten Kühlkörpers 6 verlaufend angeordnet. Die Rippen 16, 18, 20 weisen in Luftstromrichtung 22 eine konstante Länge 11, l2 auf. Eine erste Länge l1 der ersten Rippen 16 entspricht einer zweiten Länge l2 der zweiten und dritten Rippen 18, 20, wobei die Rippen 16, 18, 20 auf einer der Oberflächen 8 gegenüberliegenden Seite bündig abschließen.

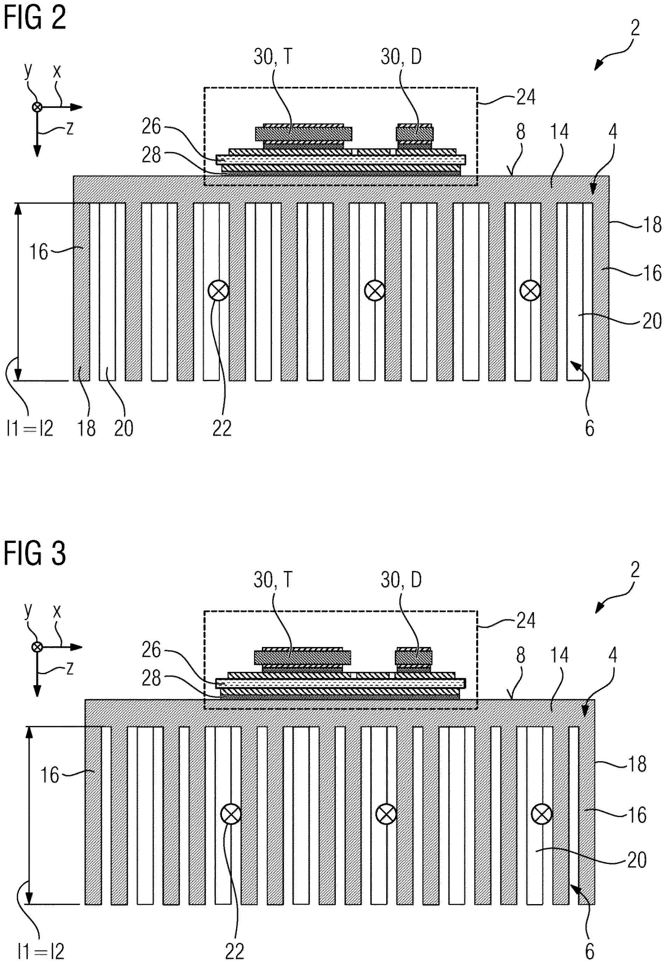

FIG 2 zeigt eine schematische Schnittdarstellung einer zweiten Ausführungsform einer Leistungshalbleiteranordnung 2, wobei die Oberfläche 8 des ersten Kühlkörpers 4 bündig zur Oberfläche 8 des zweiten Kühlkörpers 6 verlaufend angeordnet ist. Jeweils mindestens zwei, insbesondere mindestens drei, Leistungshalbleiterschaltungen 24 sind stoffschlüssig auf den Oberflächen 8 der jeweiligen Kühlkörper 4, 6 verbunden. Die Leistungshalbleiterschaltungen 24 weisen jeweils ein Substrat 26 auf, welches durch eine Lötverbindung 28 auf der Oberfläche 8 des jeweiligen Kühlkörpers 4, 6 verbunden ist. Das Substrat ist in FIG 2 als DCB-Substrat ausgeführt, wobei DCB für "direct copper bonded" steht. Auf einer der jeweiligen Oberfläche 8 abgewandten Seite des Substrats 26 sind Leistungshalbleiterelemente 30 angeordnet. Beispielhaft sind die Halbleiterelemente 30 als ein Transistor T und als eine Diode D ausgeführt. Der Transistor T ist beispielhaft als IGBT ausgeführt. Alternativ kann der Transistor T unter anderem als vertikaler SiC-MOSFET ausgeführt sein. Die zweiten Rippen 18 und dritten Rippen 20 des zweiten Kühlkörpers 6 sind alternierend angeordnet, wobei die zweiten Rippen 18 den zweiten Kühlkörper 6 beidseitig in x-Richtung begrenzen. Die weitere Ausgestaltung der Leistungshalbleiteranordnung 2 in FIG 2 entspricht der Ausführung in FIG 1.

FIG 3 zeigt eine schematische Schnittdarstellung einer dritten Ausführungsform einer Leistungshalbleiteranordnung 2, wobei zwei zweite Rippen 18 im Wechsel mit einer dritten Rippe 20 angeordnet sind und wobei die zweiten Rippen 18 den zweiten Kühlkörper 6 beidseitig in x-Richtung begrenzen. Die weitere Ausgestaltung der Leistungshalbleiteranordnung 2 in FIG 3 entspricht der Ausführung in FIG 2.

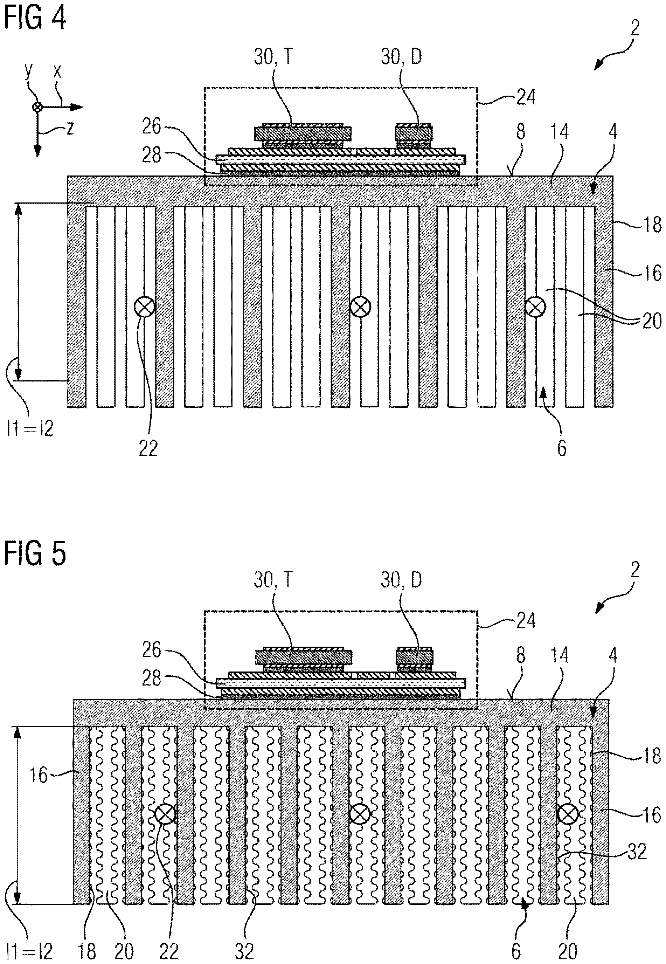

FIG 4 zeigt eine schematische Schnittdarstellung einer vierten Ausführungsform einer Leistungshalbleiteranordnung 2, wobei eine zweite Rippe 18 im Wechsel mit zwei dritten Rippen 20 angeordnet sind und wobei die zweiten Rippen 18 den zweiten Kühlkörper 6 beidseitig in x-Richtung begrenzen. Die weitere Ausgestaltung der Leistungshalbleiteranordnung 2 in FIG 4 entspricht der Ausführung in FIG 2.

FIG 5 zeigt eine schematische Schnittdarstellung einer fünften Ausführungsform einer Leistungshalbleiteranordnung 2, wobei die Rippen 18, 20 des zweiten Kühlkörpers 6 eine beispielhaft wellenförmige Profilierung 32 aufweisen. Die profilierten Rippen 18, 20 des zweiten Kühlkörpers 6 weisen entlang der Luftstromrichtung 22 ein gleichbleibendes Querschittsprofil auf, sodass auch der zweite Kühlkörper 6 kostengünstig durch Strangpressen herstellbar ist. Die Profilierung 32 der Rippen 18, 20 des zweiten Kühlkörpers 6 führt zu einer Vergrößerung der Oberfläche, was zu einer verbesserten Entwärmung der Leistungshalbleiterschaltungen 24 des zweiten Kühlkörpers 6 führt. Die weitere Ausgestaltung der Leistungshalbleiteranordnung 2 in FIG 5 entspricht der Ausführung in FIG 2.

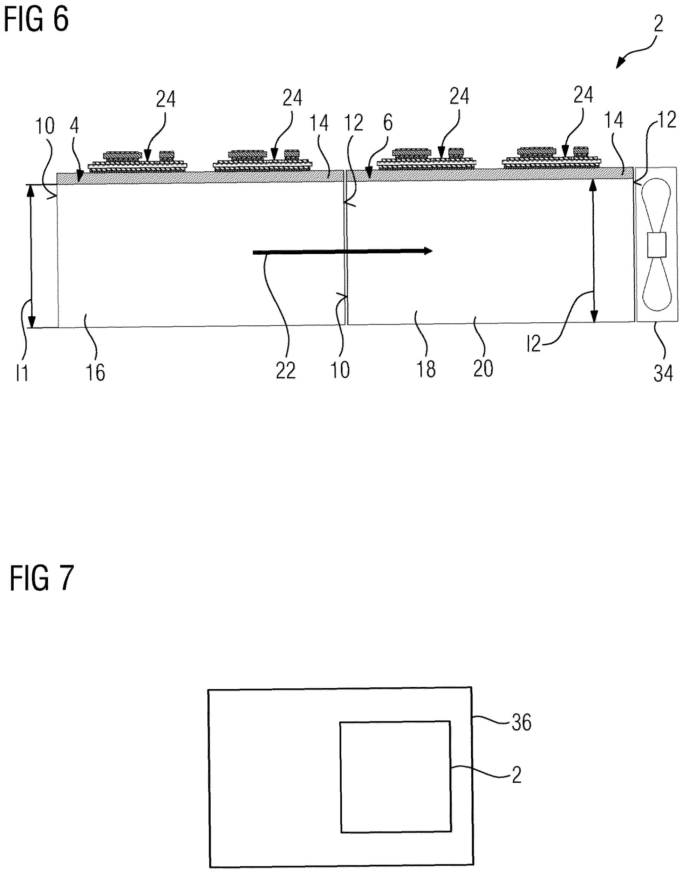

FIG 6 zeigt eine schematische Schnittdarstellung einer sechsten Ausführungsform einer Leistungshalbleiteranordnung 2, wobei beispielhaft jeweils zwei Leistungshalbleiterschaltungen 24 auf einem Kühlkörper 4, 6 entlang der Luftstromrichtung 22 angeordnet sind. Die Leistungshalbleiterschaltungen 24 des ersten Kühlkörpers 4 weisen dieselbe Schaltungstopologie auf wie die Leistungshalbleiterschaltungen 24 des zweiten Kühlkörpers 6. Ein als Sauglüfter konfigurierter Lüfter 34, welcher zur Erzeugung einer in die Luftstromrichtung 22 verlaufende Kühlluftströmung konfiguriert ist, ist unmittelbar an die zweite Seitenfläche 12 des zweiten Kühlkörpers 6 angrenzend angeordnet. Alternativ kann ein Drucklüfter unmittelbar an die erste Seitenfläche 10 des ersten Kühlkörpers 4 angrenzend angeordnet sein. Die weitere Ausgestaltung der Leistungshalbleiteranordnung 2 in FIG 6 entspricht der Ausführung in FIG 2.

FIG 7 zeigt eine schematische Darstellung eines Stromrichters 36, welcher beispielhaft eine Leistungshalbleiteranordnung 2 umfasst.

Zusammenfassend betrifft die Erfindung eine Leistungshalbleiteranordnung 2 mit einem ersten Kühlkörper 4 und einem zweiten Kühlkörper 6, wobei die Kühlkörper 4, 6 jeweils eine ebene Oberfläche 8, eine erste Seitenfläche 10 und eine gegenüber der ersten Seitenfläche 10 angeordnete zweite Seitenfläche 12 aufweisen, wobei auf den Oberflächen 8 der Kühlkörper 4, 6 jeweils zumindest eine Leistungshalbleiterschaltung 24 verbunden ist. Um die Lebensdauer der Leistungshalbleiteranordnung 2 zu verbessern wird vorgeschlagen, dass der erste Kühlkörper 4 eine Mehrzahl erster Rippen 16 und der zweite Kühlkörper 6 eine Mehrzahl zweiter Rippen 18 und dritter Rippen 20 aufweist, wobei die Rippen 16, 18, 20 des jeweiligen Kühlkörpers 4, 6 parallel von der ersten Seitenfläche 10 zur zweiten Seitenfläche 12 entlang einer Luftstromrichtung 22 verlaufend angeordnet sind, wobei der zweite Kühlkörper 6 entlang der Luftstromrichtung 22 stromab des ersten Kühlkörpers 4 angeordnet ist, wobei die zweite Seitenfläche 12 des ersten Kühlkörpers 4 unmittelbar an die erste Seitenfläche 10 des zweiten Kühlkörpers 6 angrenzt und wobei eine Anzahl der zweiten Rippen 18 des zweiten Kühlkörpers 6 gleich einer Anzahl der ersten Rippen 16 des ersten Kühlkörpers 4 ist.

## Patentansprüche

1. Leistungshalbleiteranordnung (2) mit einem ersten Kühlkörper (4) und einem zweiten Kühlkörper (6),
wobei die Kühlkörper (4, 6) jeweils eine ebene Oberfläche (8), eine erste Seitenfläche (10) und eine gegenüber der ersten Seitenfläche (10) angeordnete zweite Seitenfläche (12) aufweisen, wobei auf den Oberflächen (8) der Kühlkörper (4, 6) jeweils zumindest eine Leistungshalbleiterschaltung (24) verbunden ist,
wobei der erste Kühlkörper (4) eine Mehrzahl erster Rippen (16) und der zweite Kühlkörper (6) eine Mehrzahl zweiter Rippen (18) und dritter Rippen (20) aufweist,
wobei die Rippen (16, 18, 20) des jeweiligen Kühlkörpers (4, 6) parallel von der ersten Seitenfläche (10) zur zweiten Seitenfläche (12) entlang einer Luftstromrichtung (22) verlaufend angeordnet sind,
wobei der zweite Kühlkörper (6) entlang der Luftstromrichtung (22) stromab des ersten Kühlkörpers (4) angeordnet ist,
wobei die zweite Seitenfläche (12) des ersten Kühlkörpers (4) unmittelbar an die erste Seitenfläche (10) des zweiten Kühlkörpers (6) angrenzt und
wobei eine Anzahl der zweiten Rippen (18) des zweiten Kühlkörpers (6) gleich einer Anzahl der ersten Rippen (16) des ersten Kühlkörpers (4) ist.

2. Leistungshalbleiteranordnung (2) nach Anspruch 1,
wobei die ersten Rippen (16) des ersten Kühlkörpers (4) und die zweiten Rippen (18) des zweiten Kühlkörpers (6) fluchtend angeordnet sind.

3. Leistungshalbleiteranordnung (2) nach einem der Ansprüche 1 oder 2,
wobei jeweils mindestens zwei, insbesondere mindestens drei,
Leistungshalbleiterschaltungen (24) auf den Oberflächen (8) der jeweiligen Kühlkörper (4, 6) verbunden sind,
wobei die Leistungshalbleiterschaltungen (24) entlang der Luftstromrichtung (22) angeordnet sind.

4. Leistungshalbleiteranordnung (2) nach einem der vorherigen Ansprüche,
wobei zumindest eine Leistungshalbleiterschaltung (24) des ersten Kühlkörpers (4) dieselbe Schaltungstopologie aufweist wie zumindest eine Leistungshalbleiterschaltung (24) des zweiten Kühlkörpers (6).

5. Leistungshalbleiteranordnung (2) nach einem der vorherigen Ansprüche,
wobei die Leistungshalbleiterschaltungen (24) jeweils ein Substrat (26) umfassen, welches stoffschlüssig auf der Oberfläche (8) des jeweiligen Kühlkörpers (4, 6) verbunden ist.

6. Leistungshalbleiteranordnung (2) nach einem der vorherigen Ansprüche,
wobei zweite Rippen (18) und dritte Rippen (20) des zweiten Kühlkörpers (6) alternierend angeordnet sind.

7. Leistungshalbleiteranordnung (2) nach einem der vorherigen Ansprüche,
wobei der Quotient aus einer Anzahl von Rippen (18, 20) des zweiten Kühlkörpers (6) zu einer Anzahl von Rippen (16) des ersten Kühlkörpers (4) ganzzahlig ist.

8. Leistungshalbleiteranordnung (2) nach einem der vorherigen Ansprüche,
wobei die Kühlkörper (4, 6) jeweils monolithisch ausgeführt sind.

9. Leistungshalbleiteranordnung (2) nach Anspruch 8,
wobei die Kühlkörper (4, 6) jeweils mittels eines Strangpressverfahrens hergestellt sind.

10. Leistungshalbleiteranordnung (2) nach einem der vorherigen Ansprüche,
wobei die Oberfläche (8) des ersten Kühlkörpers (4) bündig zur Oberfläche (8) des zweiten Kühlkörpers (6) verlaufend angeordnet ist,
wobei eine erste Länge (11) der ersten Rippen (16) einer zweiten Länge (l2) der zweiten und dritten Rippen (18, 20) entspricht, sodass die Rippen (16, 18, 20) auf einer den Oberflächen (8) gegenüberliegenden Seite bündig abschließen.

11. Leistungshalbleiteranordnung (2) nach einem der vorherigen Ansprüche,
wobei ein als Drucklüfter konfigurierter Lüfter (34) unmittelbar an die erste Seitenfläche (10) des ersten Kühlkörpers (4) angrenzend angeordnet ist oder
ein als Sauglüfter konfigurierter Lüfter (34) unmittelbar an die zweite Seitenfläche (12) des zweiten Kühlkörpers (6) angrenzend angeordnet ist.

12. Leistungshalbleiteranordnung (2) nach einem der vorherigen Ansprüche,
wobei zumindest die Rippen (18, 20) des zweiten Kühlkörpers (6) eine Profilierung (32) aufweisen.

13. Stromrichter (36) mit mindestens einer Leistungshalbleiteranordnung (2) nach einem der vorherigen Ansprüche.

14. Verfahren zur Herstellung einer Leistungshalbleiteranordnung (2) mit einem ersten Kühlkörper (4) und einem zweiten Kühlkörper (6),
wobei die Kühlkörper (4, 6) jeweils eine ebene Oberfläche (8), eine erste Seitenfläche (10) und eine gegenüber der ersten Seitenfläche (10) angeordnete zweite Seitenfläche (12) aufweisen, wobei auf den Oberflächen (8) der Kühlkörper (4, 6) jeweils zumindest eine Leistungshalbleiterschaltung (24) verbunden wird,
wobei der erste Kühlkörper (4) eine Mehrzahl erster Rippen (16) und der zweite Kühlkörper (6) eine Mehrzahl zweiter Rippen (18) und dritter Rippen (20) aufweist,
wobei die Rippen (16, 18 20) des jeweiligen Kühlkörpers (4, 6) parallel von der ersten Seitenfläche (10) zur zweiten Seitenfläche (12) entlang einer Luftstromrichtung (22) verlaufend angeordnet sind,
wobei der zweite Kühlkörper (6) entlang der Luftstromrichtung (22) stromab des ersten Kühlkörpers (4) angeordnet wird,
wobei die zweite Seitenfläche (12) des ersten Kühlkörpers (4) unmittelbar an die erste Seitenfläche (10) des zweiten Kühlkörpers (6) angrenzend angeordnet wird und
wobei eine Anzahl der zweiten Rippen (18) des zweiten Kühlkörpers (6) gleich einer Anzahl der ersten Rippen (16) des ersten Kühlkörpers (4) ist.

15. Leistungshalbleiteranordnung (2) mit einem ersten Kühlkörper (4) und einem zweiten Kühlkörper (6),
wobei die Kühlkörper (4, 6) jeweils eine ebene Oberfläche (8), eine erste Seitenfläche (10) und eine gegenüber der ersten Seitenfläche (10) angeordnete zweite Seitenfläche (12) aufweisen, wobei auf den Oberflächen (8) der Kühlkörper (4, 6) jeweils zumindest eine Leistungshalbleiterschaltung (24) verbunden ist,
wobei der erste Kühlkörper (4) und der zweite Kühlkörper (6) eine Mehrzahl von Rippen (16, 18, 20) aufweisen, welche jeweils parallel von der ersten Seitenfläche (10) zur zweiten Seitenfläche (12) des jeweiligen Kühlkörpers (4, 6) entlang einer Luftstromrichtung (22) einer Kühlluftströmung verlaufend angeordnet sind,
wobei der zweite Kühlkörper (6) entlang der Luftstromrichtung (22) stromab des ersten Kühlkörpers (4) angeordnet ist,
wobei die zweite Seitenfläche (12) des ersten Kühlkörpers (4) unmittelbar an die erste Seitenfläche (10) des zweiten Kühlkörpers (6) angrenzt und
wobei die Rippen (16, 18, 20) der Kühlkörper (4, 6) jeweils eine Kontaktfläche aufweisen, welche in einer fluidtechnischen Verbindung zur Kühlluftströmung steht,
wobei die Kontaktfläche der Rippen (18, 20) des zweiten Kühlkörpers (6) größere als die Kontaktfläche der Rippen (16) des ersten Kühlkörpers (4) ist.

16. Leistungshalbleiteranordnung (2) nach Anspruch 15,
wobei die Rippen (18, 20) des zweiten Kühlkörpers (6) einen höheren Luftwiderstand aufweisen als die Rippen (16) des ersten Kühlkörpers (4).

17. Leistungshalbleiteranordnung (2) nach einem der Ansprüche 15 oder 16,
wobei zumindest die Rippen (18, 20) des zweiten Kühlkörpers (6) eine Profilierung (32) aufweisen.
